(19) Europäisches Patentamt

European Patent Office

Office européen des brevets

(11) **EP 0 939 488 A1**

(12) **EUROPEAN PATENT APPLICATION**

(43) Date of publication:
01.09.1999 Bulletin 1999/35

(51) Int. Cl.$^6$: **H03J 5/24**, H03L 1/02

(21) Application number: 98101754.4

(22) Date of filing: 02.02.1998

(84) Designated Contracting States:
**AT BE CH DE DK ES FI FR GB GR IE IT LI LU MC NL PT SE**
Designated Extension States:
**AL LT LV MK RO SI**

(71) Applicant:
**Sony International (Europe) GmbH
50829 Köln (DE)**

(72) Inventor:
**Ito, Koichi,
c/o Sony Int. (Europe) GmbH
85609 Aschheim (DE)**

(74) Representative:
**Körber, Martin, Dipl.-Phys. et al
Mitscherlich & Partner
Patentanwälte
Sonnenstrasse 33
80331 München (DE)**

(54) **Voltage controlled tuning cicuit**

(57) The present invention relates to a voltage controlled tuning circuit for tuning a resonance frequency of an oscillator, comprising a voltage controlled variable capacitance means (11; 45), a first and a second inductor means (12, 13; 46, 47) connected in series with each other and parallel to the variable capacitance means, and a band switch means (14; 49) connected in parallel to at least one of the inductor means for band switching the resonance frequency. The voltage controlled tuning circuit further comprises an adjustment means (15; 50) for adjusting the resonance frequency. The adjustment means thereby allows a quick and very precise adjustment and fine tuning of the resonance frequency to the center frequency of the respective frequency band.

Fig. 1

## Description

The present invention relates to a voltage controlled tuning circuit for tuning a resonance frequency of an oscillator, comprising a voltage controlled variable capacitance means, a first and a second inductor means connected in series with each other and parallel to the variable capacitance means, and a band switch means connected in parallel to at least one of the inductor means for band switching the resonance frequency.

Such a voltage controlled tuning circuit is for example disclosed in DE 196 47 383 A1. This known voltage controlled tuning circuit is used to tune the resonance frequency of a resonance circuit oscillator. The band switch means is a voltage controlled diode which is used to switch the tuning circuit between a lower and an upper frequency band, for example in the UHF or VHF or any other required frequency region. The variable capacitance means is a variable capacitance diode, whose capacitance is set by a control voltage. The voltage of the control voltage thus determines the resonance frequency of the tuning circuit and of the oscillator. The inductor means can for example be discrete components, dielectric poles or strip lines. Since the capacitance used in the tuning circuit and the respective oscillator usually are not accurate and show deviations, the resonance frequency is not the ideal center frequency, even if the control voltage is set to the center voltage. Therefore, the inductance of the inductor means has to be mechanically adjusted after the manufacturing process in order to obtain the accurate center resonance frequency. If the inductor means are dielectric poles or strip lines, this can be done by adjusting the length by a drilling technique, for example. By such an adjustment of the inductance of the inductor means, errors in the capacitance values of the capacitors can be absorbed and an accurate center frequency can be obtained. It is, however, impossible to tune the tuning circuit after the manufacturing process has been completed, so that errors and deviations in the tuning circuit or the oscillation circuit due to mechanical distortions, variations or similar reasons occur. Variable capacitance diode usually have a remarkable temperature diode. Therefore, a stable and accurate resonance frequency cannot be assured.

The object of the present invention is thus to provide a voltage controlled tuning circuit for tuning a resonance frequency of an oscillator according to the preamble of claim 1, which assures an improved operation accuracy and reliability.

This object is achieved by a voltage controlled tuning circuit for tuning a resonance frequency of an oscillator according to the preamble of claim 1, which is characterized by further comprising an adjustment means for adjusting the resonance frequency. The provision of an adjustment means enables a fine tuning of the resonance frequency during or after use and thus ensures an improved operation reliability and accuracy.

With the adjustment means of the present invention a mechanical adjustment during or after the manufacturing process is no longer necessary. Therefore, the manufacturing process can be shortened. Furtheron, the tolerance of each component of the circuits can be relaxed, so that cheaper elements can he used and the circuitry is cheaper to manufacture. The resonance frequency can be adjusted any time a deviation from the center frequency in the required frequency band occurs.

Advantageous features of the present invention are defined in the subclaims.

Advantageously, the adjustment means is connected in parallel to at least one of the inductor means. Thereby, the adjustment means is used to perform a fine tuning of the inductivity of both or one of the inductor means to tune the resonance frequency to the accurate center frequency.

Further advantageously, the adjustment means is a variable capacitance means, for example a variable capacitance diode. The adjustment means can be controlled by a control means. Thereby, the control means can control the adjustment means either on the basis of control information stored in a memory or on the basis of measured information. The control means can control the adjustment means also on the basis of control information stored in a memory and on the basis of measured information. Thereby, a quick and reliable fine tuning of the resonance frequency can be performed automatically.

The measured information can be a temperature information detected by a temperature detection means for a temperature compensation of the resonance frequency. This is particularly advantageous in the case of varying operating conditions, for example if the tuning circuit according to the present invention is used in a portable telephone. In this case, the control means can read temperature compensation information corresponding to the measured temperature information from a or said memory means for the temperature compensation. The temperature detection circuit comprises advantageously a thermal resistor for detecting varying temperature conditions.

Preferred embodiments of the present invention are explained in detail in the following description relating to the enclosed drawings, in which

fig. 1 shows a first embodiment of a voltage controlled tuning circuit according to the present invention,

fig. 2 shows the voltage controlled tuning circuit shown in fig. 1 comprising a temperature detection means,

fig. 3 shows a second embodiment of a voltage controlled tuning circuit according to the present invention, and

fig. 4 shows a voltage controlled tuning circuit of fig.

3 comprising a temperature detection means.

In the drawings the embodiments of a voltage controlled tuning circuit according to the present invention is shown in combination with a resonance circuit. However, the voltage controlled tuning circuit according to the present invention could be used with other oscillators, for example a quartz oscillator etc..

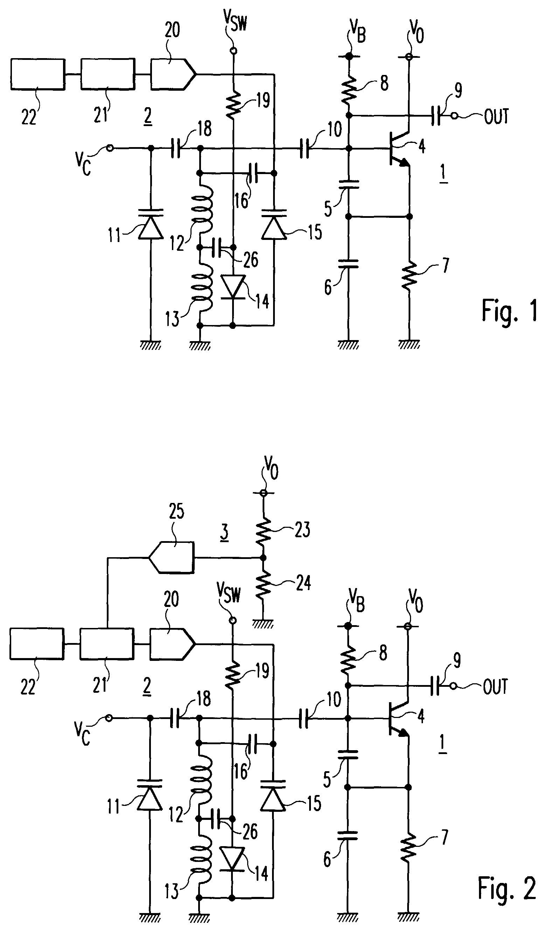

Fig. 1 shows a voltage controlled oscillator comprising a resonance circuit 1 and a voltage controlled tuning circuit 2. The resonance circuit 1 comprises a transistor 4. The emitter of the transistor 4 is grounded via a resistor 7. The base and the emitter of the resistor 4 are connected via a capacitor 5. The capacitor 5 is connected in series with a grounded capacitor 6. The base of the transistor 4 is thereby connected with an intermediate point between the capacitor 5 and the capacitor 6, so that the capacitor 5 and the capacitor 6 build a voltage divider. The base of the transistor 4 is biased by a bias voltage $V_B$ via a resistor 8. An output terminal OUT is connected via a capacitor 9 to the base of the transistor 4. The collector of the resistor 4 is operated by an operating voltage $V_O$. Thus, the basic structure of the resonance circuit shown in fig. 1 is a common emitter connection of the transistor 4.

The resonance circuit 1 is connected via a capacitor 10 to the tuning circuit 2. The tuning circuit is controlled by a voltage $V_C$, which is a DC voltage and defines the capacitance of a variable capacitance diode 11, which is grounded. A First inductor 12 and a second inductor 13 are connected in series with each other, whereby the second inductor 13 is grounded. The first and the second inductor 12 and 13 are connected in parallel to the variable capacitance diode 11. The capacitor 18 which serves as DC component cut off capacitor is connected between the first capacitor 12 and the variable capacitor diode 11.

The capacitance of the variable capacitor diode 11 is defined by the control voltage $V_C$. The resonance frequency can be varied by means of the capacitance of the variable capacitor diode 11 and the inductance of the first and the second inductor 12 and 13. The diode 14 is connected in parallel to the second inductor 13 and is controlled by a switch voltage $V_{SW}$ via a resistor 19. By means of the diode 14, the oscillator can be switched between two different frequency bands. For switching the frequency band, a DC voltage is supplied as switch voltage $V_{SW}$. If the switch voltage is a low voltage, for example zero, the diode 14, which in the shown example is a pin diode, is not on. Thus the resonance inductance value is the sum of the inductances of the first and the second inductor 12 and 13. If the switch voltage is high enough to turn on the diode 14, the diode 14 shunts the second inductor 13. Thus, the resonance inductance value is only the inductance of the first inductor 12.

The resonance frequency of the voltage controlled oscillator is determined by the following equations. The frequency $f_L$ of the lower frequency and (the switch voltage is low) is determined by the following equation:

$$f_L = \frac{1}{2\pi \sqrt{(L_1 + L_2) \cdot C}}$$

wherein $L_1$ is the inductance of the first inductor 12 and $L_2$ is the inductance of the second inductor 13 and C is the total capacitance of the capacitors contained in the oscillator circuit. The frequency $f_H$ of the higher frequency band (the switch voltage is high) is determined by the following equation:

$$f_H = \frac{1}{2\pi \sqrt{L_1 \cdot C}}$$

whereby $L_1$ is the inductance of the first inductor 12 and C is the total capacitance of all the capacitors contained in the oscillator circuit.

For adjusting and fine tuning the inductance of the first and the second inductor 12 and 13 or, if the switch voltage is high, for adjusting the inductance of only the first inductor 12, a variable capacitance diode 15 is provided as an adjustment means. The variable capacitance diode 15 is connected in parallel to the first and the second inductor 12 and 13. The variable capacitance diode is controlled by a voltage from a D/A-converter 20. A control means 21, for example central processing unit, is connected with a memory 22 and also with the D/A-converter 20. The control voltage output by the D/A-converter to the variable capacitance diode 15 is set by the control means 21. The control means 21 reads adjustment data from a memory 22, which can be pre-recorded or measured data. The control means 21 sets the output voltage of the D/A-converter so that the capacitance of the variable capacitance diode 15 is tuned and adjusted to set the resonance frequency of the oscillator circuit to the center frequency of the respective frequency band. Thereby, the capacitance of the variable capacitance diode 15 can be adjusted during use of the oscillator circuit, or before and/or after use.

In fig. 2, the voltage controlled oscillator shown in fig. 1 is shown comprising a temperature detection means 3. The temperature detection means comprises a thermal resistor 24, which is grounded. A control voltage $V_C$ is applied to the thermal resistor 24 via a normal resistor 23 connected in series to the thermal resistor 24. A A/D-converter 25 is connected to an intermediate point between the resistor 23 and the thermal resistor 24 to derive the temperature information in form of a temperature dependent voltage. The A/D-converter 25 supplies the digitized temperature information to the control means 21.

The memory 22 contains temperature compensation data, which are read by the control means 21 to provide the corresponding adjustment voltage to the respectively measured temperature. Thus, the provision of the temperature detection circuit permits a quick, precise and automatical fine adjustment of the resonance frequency to the center frequency of the respective frequency band during the use of the oscillator circuit. A capacitor 16 is connected between an intermediate point of the D/A-converter 20 and the variable capacitance diode 15 and an intermediate point of the capacitor 18 and the first inductor 12. A capacitor 18 is connected between an intermediate point of the resistor 19 and the diode 15 and an intermediate point of the inductor 12 and the inductor 13. The resistors 16 and 18 serve to cut off DC components. Although the shown tuning circuit 2 has two inductors 12 and 13, more inductors can be provided to allow switching between a plurality of frequency bands. In this case, each of the additional inductors has another diode connected in parallel to allow this particular inductor to be shunted. The adjusting of the tuning circuit according to the present invention is particularly advantageous, since even the switching between two or more frequency bands can be performed very accurately and stable, since the center frequency in each frequency band can be fine adjusted easily. The tuning circuit according to the present invention has the further advantage that no mechanical tuning of the inductance of the inductors, for example by shaping the length of strip lines etc. is necessary. Thereby, manufacturing time can be saved. Furtheron, the tuning circuit according to the present invention provides a higher stability of the generated resonance frequencies, since an automatical fine tuning can be performed. Furtheron, board space can be saved. Furtheron, elements with less tight tolerances can be used.

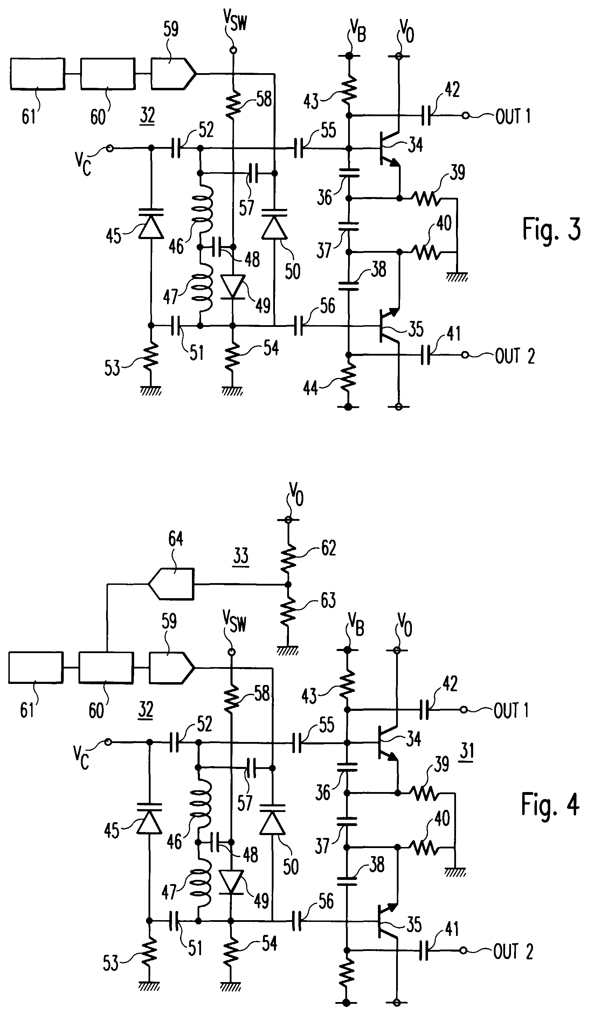

All of the above-explained functions and advantages apply identically to the embodiment of the present invention shown in figs. 3 and 4. In fig. 3 an oscillator circuit comprising a resonance circuit 31 and a tuning circuit 32 is shown. The only functional difference between the oscillator circuit shown in fig. 3 and the oscillator circuit shown in fig. 1 is that the oscillator circuit shown in fig. 3 provides the output oscillation signal differentially on two output terminals OUT1 and OUT2. The structure of the oscillator circuit shown in figs. 3 and 4 is particularly useful for implementation as integrated circuit.

The resonance circuit 31 comprises a first transistor 34 and a second transistor 35. The emitter of the transistor 34 is grounded via a resistor 39 and the emitter of the transistor 35 is grounded via a resistor 40. The emitter of the transistor 34 is connected via a capacitor 36 to the base of the transistor 34. Similarly, the emitter of the transistor 35 is connected to the base of the transistor 35 via a capacitor 38. The base of the transistor 34 is connected via a capacitor 42 to a first output terminal OUT1. The base of the second transistor 35 is connected via the capacitor 41 to the second output terminal OUT2. The base of the transistor 34 is biased via resistor 43 by a bias voltage $V_B$. The base of the transistor 35 is biased via a resistor 44 by a bias voltage $V_B$. The collector of the transistor 34 is connected to an operated control voltage $V_C$. The collector of the transistor 35 is connected to and operated by a control voltage $V_C$. The transistor 34 and the transistor 35 could also be operated by the same control voltage. Similarly, the transistor 34 and the transistor 35 could be biased by the same bias voltage. The capacitor 36 and the capacitor 38 are connected in series, whereby the capacitor 37 is connected between them so that a voltage divider is formed. Thus and as can be seen from fig. 3, the basic structure of the resonance circuit 31 is a common emitter connection.

The base of the transistor 34 is connected to a capacitor 55 and the base of the transistor 35 is connected to a capacitor 56. The capacitors 55 and 56 form the connection of the resonance circuit 31 to the tuning circuit 32. The capacitor 55 and the capacitor 56 thereby serve to cut off DC components.

The tuning circuit 32 comprises a variable capacitance diode 45, the capacitance of which is controlled by a control voltage $V_C$. A first inductor 46 and a second inductor 47 are connected in series with each other. The first inductor 46 and the second inductor 47 are connected in parallel to the variable capacitance diode 45. The variable capacitance diode 45 is grounded via a resistor 53. A capacitor 51 is connected to the second inductor 47 at an intermediate point between the resistor 53 and the variable capacitance diode 45. A capacitor 52 is connected to the first inductor 46 and the variable capacitance diode 45. The diode 49, for example a pin diode, is connected in parallel to the second inductor 47.

The diode 49 is grounded via a resistor 54. The diode 49 is controlled via a resistor 58 by a switch voltage $V_{SW}$. In case that the switch voltage is low, the diode 49 is not on and the inductance of the first and the second capacitor 46 and 47 determine the resonance frequency of the oscillator circuit. In case that the switch voltage is high, the diode 49 is on and shunts the second inductor 47 that the resonance frequency of the oscillator circuit is determined only by the inductance of the first inductor 46. The two occasions given above for the lower and the higher frequency apply identically to the second embodiment shown in figs. 3 and 4.

A capacitor 48 is connected to an intermediate point of the first and the second inductor 46 and 47 and an intermediate point of the diode 49 and the resistor 58.

As in the first embodiment shown in figs. 1 and 2, a variable capacitor diode 50 is connected in parallel to the first and the second inductor 46 and 47 for adjusting fine tuning the resonance frequency to the center frequency of the respective frequency band. The variable capacitance diode 50 is supplied with a control voltage by a D/A-converter 59. The control voltage is set by control means 60, for example a central processing unit, which is connected to a memory 61. The variable capacitance diode 50, the D/A-converter 59, the control means 60 and the memory 61 identically correspond identically to the variable capacitance diode 15, the D/A-converter 20, the control means 21 and the memory 22 of the first embodiment and have the same functions and advantages described above.

In fig. 4, the oscillator circuit shown in fig. 3 is shown comprising a temperature detection means 33. The temperature detection means 33 comprises a thermal resistor 63, which is grounded. A control voltage $V_C$ is applied to the thermal resistor 63 via a normal resistor 62 connected in series to the thermal resistor 63. The A/D-converter 64 is connected to an intermediate point of the resistor 62 and the thermal resistor 63 to derive temperature information in form of a temperature dependent voltage. The A/D-converter 64 supplies the temperature information to the control means 60. The temperature detection circuit 43 has the same advantages and functions as the temperature detection circuit 3 described above for the first embodiment, so that further description is omitted.

## Claims

1. Voltage controlled tuning circuit for tuning a resonance frequency of an oscillator, comprising

    a voltage controlled variable capacitance means (11; 45),
    a first and a second inductor means (12, 13; 46, 47) connected in series with each other and parallel to the variable capacitance means (14, 49), and
    a band switch means (14, 49) connected in parallel to at least one of the inductor means for band switching the resonance frequency,
    **characterized by**
    further comprising an adjustment means (15, 50) for adjusting the resonance frequency.

2. Voltage controlled tuning circuit according to claim 1,
    **characterized in,**
    that the adjustment means (15, 50) is connected in parallel to at least one of the inductor means (12, 13; 46, 47).

3. Voltage controlled tuning circuit according to claim 1 or 2,
    **characterized in,**
    that the adjustment means (15; 50) is a variable capacitance means.

4. Voltage controlled tuning circuit according to claim 1, 2 or 3

**characterized in,**
that the adjustment means (15; 50) is controlled by a control means (21; 60).

5. Voltage controlled tuning circuit according to claim 4,
    **characterized in,**
    that the control means controls (21; 60) the adjustment means (15; 50) on the basis of control information stored in a memory (22; 61).

6. Voltage controlled tuning circuit according to one of the preceding claims,
    **characterized in,**
    that the control means (21; 60) controls the adjustment means (15; 50) on the basis of measured information.

7. Voltage controlled tuning circuit according to claim 6,
    **characterized in,**
    that the measured information is a temperature information detected by a temperature detection means (3, 33) for temperature compensation of the resonance frequency.

8. Voltage controlled tuning circuit according to claim 7,
    **characterized in,**
    that the control means (21; 60) reads temperature compensation information corresponding to the measured temperature information from a or said memory means (22; 61) for the temperature compensation.

9. Voltage controlled tuning circuit according to claim 8,
    **characterized in,**
    that the temperature detection circuit (3, 33) comprises a thermal resistor (24; 63).

Fig. 1

Fig. 2

Fig. 3

Fig. 4

European Patent
Office

**EUROPEAN SEARCH REPORT**

Application Number

EP 98 10 1754

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 4 369 417 A (KUPFER KARL-HEINZ) | 1,2,4,6,7,9 | H03J5/24 H03L1/02 |
| Y | * column 2, line 40 - column 3, line 51; figure 1 * | 3,5,8 | |
| X | US 4 996 599 A (ANDERSON WILLIAM D) * column 3, line 4 - column 5, line 11; figures 1-3 * | 1,3 | |
| Y | US 3 713 033 A (FRERKING M) * column 2, line 40 - column 5, line 64; figures 1,2 * | 5,8 | |
| Y | EP 0 744 836 A (MEIDENSHA ELECTRIC MFG CO LTD) * figure 1 * | 5,8 | |
| Y | FR 2 437 731 A (QUARTZ & ELECTRONIQUE) * page 5, line 3 - page 7, line 2; figure 1 * | 3 | |
| D,A | DE 196 47 383 A (ALPS ELECTRIC CO LTD) * the whole document * | 1 | TECHNICAL FIELDS SEARCHED (Int.Cl.6) H03J H03L |

-----

The present search report has been drawn up for all claims

| Place of search | Date of completion of the search | Examiner |
|---|---|---|
| THE HAGUE | 7 April 1998 | Ratajski, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document